Europäisches Patentamt

European Patent Office

Office européen des brevets

(11) Publication number: **0 435 147 A2**

# EUROPEAN PATENT APPLICATION

(21) Application number: 90124715.5

(22) Date of filing: **19.12.90**

(51) Int. Cl.⁵: **G03F 7/00**

(30) Priority: **28.12.89 US 461469**

(43) Date of publication of application:
**03.07.91 Bulletin 91/27**

(84) Designated Contracting States:
**CH DE FR GB IT LI NL**

(71) Applicant: **E.I. DU PONT DE NEMOURS AND COMPANY**
**1007 Market Street**
**Wilmington Delaware 19898(US)**

(72) Inventor: **Smothers, William Karl**
**R.D. 2, Box 103, Old Public Road**
**Hockessin, Delaware 19707(US)**
Inventor: **Monroe, Bruce Malcolm**
**3030 Maple Shade Lane**
**Wilmington, Delaware 19810(US)**

(74) Representative: **von Kreisler, Alek,**
**Dipl.-Chem. et al**
**Patentanwälte Von Kreisler-Selting-Werner,**
**Deichmannhaus am Hauptbahnhof**
**W-5000 Köln 1(DE)**

(54) Elements for recording volume transmission holograms.

(57) An element for recording volume transmission holograms is provided comprising a photopolymerizable layer on a reflective backing. The layer contains (a) a cellulose ester, polystyrene, styrene copolymer, or poly(methyl methacrylate) binder, (b) a liquid monomer, and (c) a photoinitiator.

EP 0 435 147 A2

# ELEMENTS FOR RECORDING VOLUME TRANSMISSION HOLOGRAMS

## Field of the Invention

This invention relates to holography, and, more particularly, to volume transmission holograms for graphic arts applications.

## Background of the Invention

To make a volume hologram, the object to be imaged is illuminated with coherent light and a light sensitive recording medium is positioned so as to receive light reflected from the object. This beam of reflected light is known as the object beam. At the same time, a portion of the coherent light is directed to the recording medium, bypassing the object. This beam is known as the reference beam. The interference pattern that results from the interaction of the reference beam and the object beam impinging on the recording medium is recorded in the recording medium producing the hologram. When the processed recording medium is subsequently illuminated and observed at the appropriate angle, the light is diffracted by the hologram to reconstruct the recorded wavefront.

Holograms formed by directing the reference and object beams to enter the recording medium from the same side are known as transmission holograms. Interaction of the object and reference beams in the recording medium forms fringes of material having varying refractive indices that are approximately normal to the plane of the recording medium. When the hologram is played back by viewing with transmitted light, these fringes refract the light to produce the viewed virtual image. Transmission holograms may be produced by methods which are well known in the art, such as disclosed in Leith and Upatnieks, U.S. Patents 3,506,327; 3,838,903; and 3,894,787.

Holograms formed by directing the reference and object beams to enter the recording medium from opposite sides, so that they are traveling in approximately opposite directions, are known as reflection holograms. Interaction of the object and reference beams in the recording medium forms fringes of material with varying refractive indices which are parallel to the plane of the recording medium. When the hologram is played back these fringes act as partial mirrors reflecting incident light back to the viewer. Hence, the hologram is viewed in reflection rather than in transmission.

Reflection holograms are essentially monochromatic and only reflect the wavelength that was used to record the hologram. For some applications, such as graphic arts applications, it is desired to have a hologram that recreates the recorded image over a broader range of the visible spectrum. This effect is normally achieved by mounting a transmission hologram on a reflecting backing, and viewing the hologram with light reflected from the backing.

In practice, the transmission hologram is formed in the recording medium while temporarily supported by a non-reflecting substrate, and then the recording medium is transferred to a permanent reflecting substrate. This transfer step has been necessary with conventional recording media since efforts to record the transmission hologram on a reflecting substrate also have created a reflection hologram in the media, adversely affecting quality of the transmission hologram. However, the transfer step is time consuming and may cause damage to the hologram. Thus, there is a need for an improved element and process for recording volume transmission holograms on reflective backings.

## SUMMARY OF THE INVENTION

The present invention provides an element for recording a volume transmission hologram comprising:
(1) a reflective backing, and
(2) a photopolymerizable layer consisting essentially of
    (a) a solvent soluble, thermoplastic polymeric binder selected from the group consisting of cellulose esters, polystyrene, copolymers of styrene containing at least about 60% styrene, and poly(methyl methacrylate);
    (b) at least one liquid ethylenically unsaturated monomer capable of addition polymerization and having a boiling point above 100°C, and
    (c) a free radical generating system activatable by actinic radiation.
In a preferred embodiment of this invention either said unsaturated monomer or said binder contains a substituent selected from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine and mixtures thereof; and the other constituent is substantially free of said substituent.

In another embodiment, the invention provides a process for preparing a volume transmission hologram comprising:
(a) forming, on a reflecting backing, a photopolymerizable layer consisting essentially of

(1) a solvent soluble, thermoplastic polymeric binder selected from the group consisting of cellulose esters, polystyrene, copolymers of styrene containing at least about 60% styrene, and poly(methyl methacrylate);

(2) at least one liquid ethylenically unsaturated monomer capable of addition polymerization and having a boiling point above 100°C,

(3) a free radical generating system activatable by actinic radiation; to form a photosensitive element, and

(b) exposing the photosensitive element to modulated actinic radiation bearing holographic information, wherein the reference and object beams enter the photopolymerizable layer on the same side.

Volume transmission holograms prepared in accordance with the invention have excellent viewing characteristics.

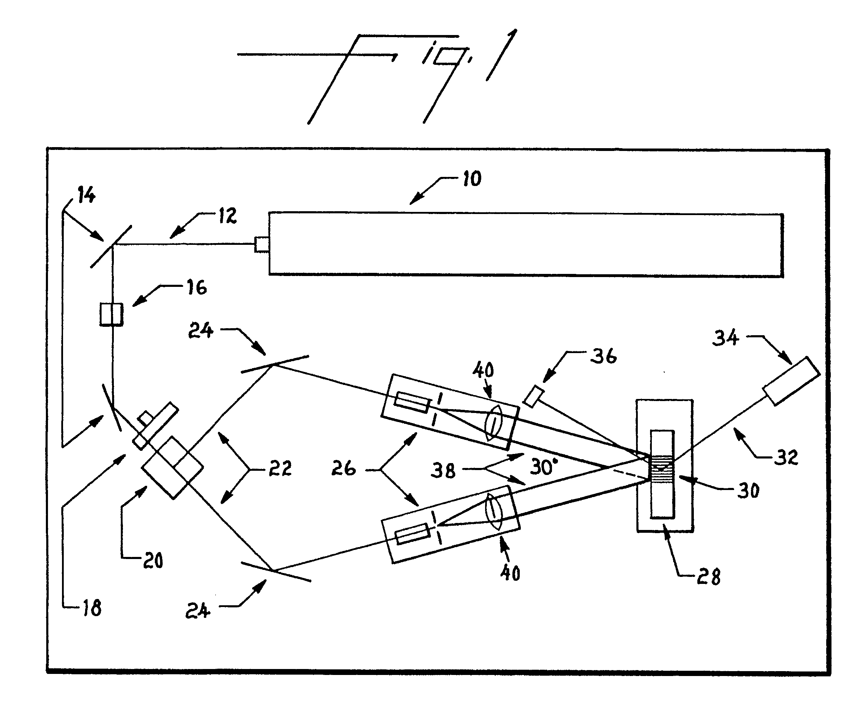

## Brief Description of the Drawing

The figure illustrates the experimental arrangement used to prepare transmission holograms mounted reflective backings.

## Detailed Description of the Invention
## Photopolymerizable Composition

The photopolymerizable compositions used in the practice of the invention are thermoplastic and contain a binder, a monomer capable of undergoing free radical addition polymerization and crosslinking, and a free radical generating photoinitiating system. The composition is applied as a substantially solid layer on a permanent reflecting backing. Upon exposure to actinic radiation containing holographic information (i.e., coherent light, as from a laser), the composition forms polymers of higher molecular weight that change the refractive index and rheological character of the composition to record a volume transmission hologram without simultaneously recording a reflection hologram. Although the layer is solid composition, components interdiffuse before, during and after imaging exposure until they are fixed or destroyed by a final uniform treatment, usually by uniform exposure to actinic radiation. Interdiffusion may be further promoted by incorporation into the composition of an otherwise inactive plasticizer. In addition to the liquid monomer, the composition may contain solid monomer components capable of interdiffusing in the solid composition and reacting with the liquid monomer to form a copolymer.

## Monomers/Binders

The binder serves as a matrix for the monomer and photoinitiator system prior to exposure and, after exposure, contributes to the physical and refractive index characteristics needed to form a the hologram. Cohesion, adhesion, flexibility, miscibility, and tensile strength are some of the properties to be considered in binder selection.

Surprisingly, it has been found that with photopolymerizable compositions containing certain binders it is possible to record transmission holograms without interference from the light reflected by the reflective backing. These binders are selected from the group consisting of cellulose esters, polystyrene, copolymers of styrene containing at least about 60% styrene, and poly(methyl methacrylate). Preferred binders are cellulose acetate butyrate, polystyrene, poly(methyl methacrylate), 70:30 poly(styrene-methyl methacrylate), and 75:25 poly (styrene-acrylonitrile).

In the preferred compositions of this invention either the unsaturated monomer or the binder contains a substituent selected from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine and mixtures thereof; and the other constituent is substantially free of said substituent. In the instance when the monomer contains the substituent, the photopolymerizable system hereinafter is identified as a "Monomer Oriented System" and when the polymeric material contains this substituent, the photopolymerizable system hereinafter is identified as a "Binder Oriented System".

The monomer of a Monomer Oriented System is a compound capable of free radical initiated addition polymerization and having a boiling point above 100°C, preferably above 150°C, which contains one or more moieties taken from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine. The monomer contains at least one such moiety and may contain two or more of the same or different moieties of the group. A liquid monomer will generally be selected, but solid monomers can be used to advantage, either individually or in combination with one or more liquid monomers, provided the solid monomer is capable of interdiffusion in the substantially solid film composition.

A preferred class of monomers for use in the Monomer Oriented System are liquid, ethylenically unsaturated compounds capable of addition polymerization and having a boiling point above 100°C, preferably above 150°C, which contain one or more moieties taken from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine. The monomer contains at least one such moiety and may contain two or more of the same or different moieties of the group, provided the monomer remains liquid. Contemplated as equivalent to the groups are substituted groups where the substitution may be lower alkyl, alkyloxy, hydroxy, phenyl, phenoxy, carboxy, carbonyl, amino, amido, imido or combinations thereof, provided that the monomer remains liquid and diffusable in the photopolymerizable layer.

Preferred liquid monomers for use in the Monomer Oriented System are: 2-phenoxyethyl acrylate, 2-phenoxyethyl methacrylate, phenol ethoxylate monoacrylate, 2-(p-chlorophenoxy)ethyl acrylate, p-chlorophenyl acrylate, phenyl acrylate, 2-phenylethyl acrylate, 2-(1-naphthyloxy)ethyl acrylate, o-biphenyl methacrylate, o-biphenyl acrylate, and mixtures thereof.

While most monomers useful in the Monomer Oriented System are liquids, they may be used in admixture with one or more ethylenically unsaturated solid monomers such as the ethylenically unsaturated carbazole monomers disclosed in H. Kamogawa, et al., Journal of Polymer Science: Polymer Chemistry Edition, Vol. 18 (1979), pp 9-18; 2-naphthyl acrylate; pentachlorophenyl acrylate; 2,4,6-tribromophenyl acrylate; 2-(2-naphthyloxy)-ethyl acrylate; N-phenyl maleimide; p-biphenyl methacrylate; 2-vinylnaphthalene; 2-naphthyl methacrylate; N-phenyl methacrylamide; and t-butylphenyl methacrylate.

Ethylenically unsaturated carbazole monomers containing a vinyl group attached to the nitrogen atom of the carbazole moiety typically are solids. Suitable monomers of this type include N-vinyl carbazole and 3,6-dibromo-9-vinyl carbazole. Preferred solid monomers are N-vinyl carbazole; 2,4,6-tribromophenyl acrylate or methacrylate; pentachlorophenyl acrylate or methacrylate; 2-naphthyl acrylate or methacrylate; 2-(2-naphthyloxy)ethyl acrylate or methacrylate; and mixtures thereof.

If crosslinking of the photopolymer is desired, up to about five weight percent of at least one multifunctional monomer containing two or more terminal ethylenically unsaturated groups may be incorporated into the composition. The polyfunctional monomer must be compatible with the other components of the composition and is preferably a liquid. Suitable multifunctional monomers include di-(2-acryloxyethyl)ether of bisphenol A, ethoxylated bisphenol A diacrylate, and the like. A preferred crosslinking is ethoxylated bisphenol A diacrylate.

The binder of the Monomer Oriented System is substantially free of substituted or unsubstituted phenyl, biphenyl, phenoxy, naphthyl, naphthyloxy, and heteroaromatic groups containing up to three aromatic rings; chlorine; and bromine. Preferred binders for the Monomer Oriented System are cellulose acetate butyrate and poly(methyl methacrylate).

The monomer of a Binder Oriented System is a compound capable of free radical initiated addition polymerization and having a boiling point above 100°C, preferably above 150°C, which contains one or more moieties taken from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine. Representative monomers for the binder orientated system are triethyleneglycol diacrylate and dimethacrylate, diethyleneglycol diacrylate, decanediol diacrylate, ethoxyethoxyethyl acrylate, and iso-bornyl acrylate.

The binder of the Binder Oriented System contains in its polymeric structure moieties taken from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine. Preferred binders for the Binder Oriented System are polystyrene and copolymers containing at least about 60% styrene. Particularly preferred binders include polystyrene, 75:25 poly(styrene/acrylonitrile), and 70:30 poly(styrene/methyl methacrylate), as well as mixtures thereof.

Photoinitiator System

The initiator system comprises one or more compounds which directly furnish free-radicals when activated by actinic radiation. By "actinic radiation" is meant radiation which is active to produce the free-radicals necessary to initiate polymerization of the monomeric material. It can also comprise a plurality of compounds, one of which yields the free-radicals after having been caused to do so by another compound, or sensitizer, which is activated by the radiation. Photoinitiator systems useful in practicing this invention typically will contain a photoinitiator and a sensitizer which extends the spectral response into the near ultraviolet, the visible, and/or near infrared spectral regions.

A large number of free-radical generating compounds can be utilized in the practice of this invention. Redox systems, especially those involving dyes, may be used. Photoreducible dyes and reducing agents, as well as dyes of the phenazine, oxazine, and quinone classes; ketones; quinones; dye-borate complexes as disclosed in U.S. Patent 4,772,541; and trichloromethyl triazines as disclosed in U.S. patents 4,772,534 and 4,774,163 can be used to initiate photopolymerization. A useful discussion of dye sensitized photopolymerization can be found in "Dye Sensitized Photopolymerization" by D. F. Eaton in Adv. in Photochemistry, Vol. 13, D. H. Volman, G. S. Hammond, and K. Gollinick, eds., Wiley-Interscience, New York, 1986, pp. 427-487.

Preferred initiator systems are 2,4,5-triphenylimidazolyl dimers with chain transfer agents, or hydrogen donors, and mixtures thereof, sensitized by visible sensitizers. Preferred 2,4,5-triphenyl-imidazolyl dimers include CDM-HABI, i.e., 2-(o-chlorophenyl)-4,5-bis(m-methoxyphenyl)-imidazole dimer; o-Cl-HABI, i.e., 1,1'-biimidazole, 2,2'-bis (o-chlorophenyl)-4,4'5,5'-tetraphenyl-; and TCTM-HABI, i.e., 1H-imidazole, 2,5-bis(o-chlorophenyl)-4-[3,4-dimethoxyphenyl]-, dimer, each of which is typically used with a hydrogen donor.

A preferred group of sensitizers include the bis(p-dialkylaminobenzylidine) ketones disclosed in Baum and Henry, U.S. Patent 3,652,275 and the arylyidene aryl ketones disclosed in Dueber, U.S. Patent 4,162,162. Particularly preferred sensitizers include the following: DEAW, i.e., cyclopentanone, 2,5-bis[4-(diethylamino)phenyl]methylene]-, CAS 38394-53-5; JAW, i.e., cyclopentanone, 2,5-bis[-(2,3,6,7-tetrahydro-1H,5H-benzo[i,j]quinolizin-1-yl)-methylene]-; cyclopentanone, 2,5-bis[2-(1,3-dihydro-1,3,3-trimethyl-2H-indol-2-ylidene)-ethylidene],CAS 27713-85-5; and cyclopentanone, 2,5-bis-[2-ethylnaphtho[1,2-d]thiazol-2(1H)-ylidene)-ethylidene], CAS 27714-25-6.

Suitable hydrogen donors include: 2-mercaptobenzoxazole, 2-mercaptobenzothiazole, 4-methyl-4H-1,2,4,triazole-3-thiol, and the like. Other suitable hydrogen donor compounds, which are preferred for compositions which contain N-vinyl carbazole monomer, are 5-chloro-2-mercaptobenzothiazole; 2-mercaptobenzothiazole; 1H-1,2,4-triazole-3-thiol; 6-ethoxy-2-mercaptobenzothiazole; 4-methyl-4H-1,2,4-triazole-3-thiol; 1-dodecanethiol; and mixtures thereof.

Other Components

Other components conventionally added to photopolymer compositions can be present to modify the physical properties of the film. Such components include: plasticizers, thermal stabilizers, optical brighteners, ultraviolet radiation absorbing material, adhesion modifiers, coating aids, and release agents.

A plasticizer may be present to modify adhesion, flexibility, hardness, and other mechanical properties of the film in a conventional fashion. Candidate plasticizers include triethylene glycol dicaprylate, triethylene glycol bis(2-ethylhexanoate), tetraethylene glycol diheptanoate, diethyl sebacate, dibutyl suberate, tris(2-ethylhexyl) phosphate, Brij® 30 [$C_{12}H_{25}(OCH_2CH_2)4OH$], and Brij® 35 [$C_{12}H_{25}(OCH_2CH_2)_{20}OH$]. Other plasticizers that yield equivalent results will be apparent to those skilled in the art.

In cases in which a mixture of a solid and a liquid monomer are present, it will also be appreciated that plasticizer may be substituted for some or all of the liquid monomer, provided that the mixture of plasticizer and monomer remains liquid. It will also be appreciated that a mixture of plasticizer and solid monomer may be used, provided that the mixture of plasticizer and monomer remains liquid.

Normally a thermal polymerization inhibitor will be present to improve the storage stability of the photopolymerizable composition. Useful thermal stabilizers include: hydroquinone, p-methoxyphenol, alkyl and aryl-substituted hydroquinones and quinones, t-butyl catechol, pyrogallol, beta-naphthol, 2,6-di-t-butyl-p-cresol, phenothiazine, and chloranil. The dinitroso dimers described in Pazos, U.S. Patent 4,168,982, are also useful. Since monomers generally contain thermal polymerization inhibitors added by their manufacturers, it is frequently unnecessary to add additional inhibitor.

Nonionic surfactants may be added to the photopolymerizable composition as coating aids. Typical coating aids are fluorinated nonionic surfactants, such as Fluorad® FC-430 and Fluorad® FC-431, as well as polyethylene oxides, such as Polyox® WSRN 3000.

Useful optical brighteners include those disclosed in Held, U.S. Patent 3,854,950. An representative optical brightener is 7-(4'-chloro-6'-diethylamino-1',3',5'-triazine-4'-yl) amino 3-phenyl coumarin. Ultraviolet radiation absorbing materials useful in the invention are also disclosed in Held, U.S. Patent 3,854,950.

Composition

Proportions of ingredients in the photopolymerizable composition will generally be within the following percentage ranges, based on the total weight of the composition: binder 25 to 90%, preferably 45 to 75%; monomer(s), 5 to 60%, preferably, 15 to 50%; plasticizer, 0 to 25%, preferably, 0 to 15%; photoinitiator system, 0.1 to 10%, preferably 1 to 7%; and optional ingredients, 0 to 5%, typically 1 to 4%. If the amount of binder is below approximately 25%, or the amount of monomer exceeds approximately 60%, the composition has insufficient viscosity to form a solid film. At high levels of binder addition, exceeding approximately 90%, performance is unduly lost, and the resulting films have diminished values of refractive index modulation. Likewise, levels of monomer(s) used will be at least approximately 5% since lower quantities will not produce films having practical values of refractive index modulation.

## Reflective Backing

The photopolymerizable compositions of this invention are substantially solid and are used as a layer applied to a reflective backing. The reflective backing should be uniform and free of defects such as pinholes, bumps, and scratches. It can be a support, such as paper, glass, synthetic resin or the like, which has been coated by vapor deposition or sputtering or by chemical deposition with a reflective metal, such as aluminized polyethylene terephthalate film. As another alternative, the reflective backing may be a polished metal plate, such as aluminum, silver or the like, or a front surface mirror. A preferred material is aluminized polyethylene terephthalate film.

## Coating

The photopolymerizable layer is prepared by mixing the ingredients of the photopolymerizable system in a solvent, such as dichloromethane, usually in the weight ratio of about 15:85 to 25:75 (solids to solvent), coating on the substrate, and evaporating the solvent. The composition may be directly coated onto the reflective backing by any conventional method to produce a uniform coating. Coating thickness will depend on the refractive index modulation of the resulting hologram and the amount of refraction required for the intended application. If desired, after the solvent evaporates a protective release film, or coversheet, may be placed placed over the photopolymerizable layer to protect it during handling and exposure.

Alternatively, the photopolymerizable layer can be coated on a non-reflective material, preferably a release film such as polyethylene or polypropylene. After removal of the coversheet, if present, the coated film can then be laminated to the reflective backing prior to imaging with the tacky, photopolymerizable layer adjacent to the reflective backing. The release film then acts as a coversheet.

## Exposure/Hologram Formation

This measurement is achieved using the 30° holographic grating system illustrated in the Figure. In the system an argon ion laser (10) operating at 488 nm and TEM$_{oo}$ produces a laser beam (12) which is directed by mirrors (14) and a beam elevator (16) through an attenuator (18) and into a beam splitter (20) wherein the beam is divided into two equal beam segments (22). Each beam segment (22) is reflected by a mirror (24), through a spatial filter and collimator (26) to converge in the plane of glass mounted sample (28) to subtend an angle of 30° whose bisector is normal to the plane of the sample (28) so as to form a grating hologram (30). Grating (30) formation is measured in real time by passing a 633 nm beam (32) from a He:Ne laser (34) through the center of the exposure area at the Bragg angle and the intensity of the laser beam (32) passing through the sample (28) is monitored with a detector (36). The aluminized polyethylene terephthalate transmits a small amount of the 633 nm radiation.

In the practice of this invention a film element is prepared comprising a reflective backing having coated thereon a solid photopolymerizable layer thick which, optionally, is protected with a coversheet. A section of the film element is cut, and the coversheet, if present, removed. Then the film is mounted onto a 10x13 cm glass plate by hand laminating the uncovered layer surface to the glass surface. Even though the layer is solid its surface typically is tacky and adheres readily to the glass surface. In those instances where tack is absent, heat and pressure may be used to laminate the photopolymerizable layer to the glass substrate surface. Typically the polyethylene terephthalate film support is left in place on the laminate and serves to protect the layer during handling and exposure operations.

The glass mounted photopolymerizable layer (28) is evaluated in the 30° holographic grating system described above wherein the emerging collimated beam (38) intensity ratio is maintained at 1:1, with absolute intensities ranging from 3-10 mW/cm$^2$ per beam (38). The diameter of each emerging beam (38) is about 1 cm. The photopolymerizable layer (28) is exposed for 4-8 seconds to the modulated laser radiation at the convergence of beams (38) corresponding to 50-100 mJ/cm$^2$ total exposure. About one minute after this image-wise exposure the grating is reexposed for 1-2 minute using one of the two emerging beams (38) to fix or complete polymerization throughout the photopolymerizable layer (28). As described earlier, grating (30) formation is monitored using the non-actinic 633 nm beam (32) of a He:Ne laser (34) and a detector (36) which is a Coherent model 212 power meter attached to a strip chart recorder.

Industrial Applicability

The elements and processes of this invention are adapted for the production of transmission holograms mounted on a reflective backing. These holograms have the advantages of transmission holograms, but can be viewed in reflection. These holograms are suited for use in displays as, for example, in advertising or packaging; in security applications as, for example, on credit cards, bank notes, lottery tickets, and the like; and for information storage.

The advantageous properties of this invention can be observed by reference to the following examples which illustrate, but do not limit, the invention.

EXAMPLES

GLOSSARY

| CAB | Cellulose acetate butyrate, Eastman type 531-1; CAS 9004-36-8 |
| DEAW | Cyclopentanone, 2,5-bis[[4-(diethylamino)-2-methylphenyl]-methylene]- |
| 2-MBO | 2-Mercaptobenzoxazole; 2-Benzoxazolethiol; CAS 2382-96-9 |
| MHQ | Methyl hydroquinone; 4-methoxy phenol |
| TCTM-HABI | 1H-Imidazole, 2,5-bis(o-chlorophenyl)-4-[3,4-dimethoxyphenyl]-, dimer; CAS 79070-04-5 |
| TDA | Triethyleneglycol diacrylate; CAS-1680-21-3 |
| TDC | Triethyleneglycol dicaprylate; CAS-106-10-5 |

EXAMPLE 1 AND CONTROL EXAMPLE A

These examples illustrate that a diffraction grating can be formed from a photopolymerizable layer coated on a reflective backing and that the grating is similar to one formed from a layer of the same composition coated on a transparent backing.

Sample Preparation

Coating solutions without visible sensitizer, DEAW, were prepared under yellow light. After addition of DEAW, all operations on solutions and their resulting coatings were performed under red light only. To further protect them from actinic light, all solutions were prepared and stored in amber bottles. Solutions were prepared by adding components to the solvent and mixing with a mechanical stirrer until they completely dissolved. All components were used as received from the suppliers. It should be understood that "total solids" refers to the total amount of nonvolatile material in the coating solution even though some of the additives may be nonvolatile liquids at ambient temperature.

The following composition was prepared: 131.52 g (54.9% of total solids) CAB; 64.80 g (27.0%) TDA; 36.00 g (15.0%) TDC; 2.40 g (1.0%) TCTM-HABI; 4.80 g (2.0%) 2-MBO; 0.108 g (0.045%) DEAW; and 0.025 g (0.010%) MHQ dissolved in 760 g of solvent composed of 80% (by weight) dichloromethane, 10% chloroform, and 10% methanol. The solution was divided into two portions. One portion was coated onto 7 mil (180 micron) polyethylene terephthalate film; the other portion was coated onto the metallized side of 4 mil (100 micron) aluminized polyethylene terephthalate film using a 15 mil (380 micron) doctor knife.

The solutions were coated onto the film support at a speed of 8 ft/min (4 cm/sec) using a Talboy coater equipped with a doctor knife, 12 ft (3.7 M) drier set at 50-70°C, and a laminator station. A coversheet 0.9 mil (23 micron) polyethylene terephthalate film was laminated to the coatings as they emerged from the drier. Coating samples were stored in black polyethylene bags at room temperature until used. Coating thickness was about 50 microns. The aluminized polyethylene terephthalate film had an optical density of 2.46 (about 0.35% transmission) at 488 nm and an optical density of 2.55 (about 0.28% transmission) at 633 nm.

Sample Evaluation

Coated film was cut into 10x13 cm sections, the coversheet was removed, and the film then mounted by laminating the tacky coating directly to a glass plate with a hand roller.

A series of gratings was constructed by interfering two laser beams at 30° using the 488 nm line of an argon ion laser as illustrated by the figure. The beam intensity ratio was maintained at about 1:1, with absolute intensities of each beam ranging from 3-10 mW/cm² per beam. The diameter of each beam was about about 1 cm. Exposure times varied from 1 sec to 8 sec. A series of exposure times was investigated for each system so that the maximum diffraction efficiency could be determined. After exposure, the sample was allowed to stand for 1 min and the the image was fixed by a 2 min exposure from a single laser beam generated by blocking one of the two interfering beams.

Since the material is not sensitive to red light, grating formation during exposure could be monitored by the increase in diffraction of the 633 nm line of a He:Ne laser. Grating formation was monitored by a He:Ne laser placed at the Bragg angle and a Coherent model 212 power meter detector attached to a strip chart recorder. The intensity of the radiation passing through the sample was measured before exposure; the intensity of the diffracted radiation was measured during and after exposure. It was possible to measure the diffraction efficiency of the sample coated on aluminized polyethylene terephthalate by this method since a small amount of light is transmitted through the coating and reflective backing.

The sample mounted on 7 mil (180 micron) polyethylene terephthalate film had a maximum diffraction efficiency of 93% after overall exposure. The sample mounted on the metallized side of 4 mil (100 micron) aluminized polyethylene terephthalate film had a maximum efficiency of 98% after overall exposure.

## Claims

1. An element adapted for preparing a volume transmission hologram, comprising:
    (1) a reflective backing,
    (2) a photopolymerizable layer consisting essentially of
        (a) a solvent soluble, thermoplastic polymeric binder selected from the group consisting of cellulose esters, polystyrene, styrene copolymers containing at least about 60% styrene, and poly(methyl methacrylate);
        (b) at least one liquid ethylenically unsaturated monomer capable of addition polymerization and having a boiling point above 100°C, and
        (c) a free radical generating system activatable by actinic radiation.

2. The element of claim 1 wherein either said monomer or said binder contains a substituent selected from the group consisting of (a) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (b) chlorine; (c) bromine; and (d) mixtures thereof; and the other constituent is substantially free of said substituent.

3. The element of claim 2 wherein said monomer has a boiling point greater than 150°C.

4. The element of claim 2 wherein said binder is selected from the group consisting of cellulose esters, polystyrene, copolymers of styrene containing at least about 60% styrene, and poly(methyl methacrylate).

5. The element of claim 2 wherein said binder is selected from the group consisting of cellulose acetate butyrate, polystyrene, poly(methyl methacrylate), 70:30 poly(styrene-methyl methacrylate), and 75:25 poly(styrene-acrylonitrile).

6. The element of claim 2 wherein said monomer is selected from the group consisting of 2-phenoxyethyl acrylate, 2-phenoxyethyl methacrylate, phenol ethoxylate monoacrylate, 2-(p-chlorophenoxy)ethyl acrylate, p-chlorophenyl acrylate, phenyl acrylate, 2-phenylethyl acrylate, 2-(1-naphthyloxy)ethyl acrylate, o-biphenyl methacrylate, o-biphenyl acrylate, and mixtures thereof.

7. The element of claim 2 in which a solid ethylenically unsaturated monomer is also present.

8. The element of claim 7 in which the solid ethylenically unsaturated monomer contains a carbazole group.

9. The element of claim 7 in which said solid ethylenically unsaturated monomer is selected from the group consisting of N-vinyl carbazole; 2,4,6-tribromophenyl acrylate or methacrylate; pentachlorophenyl acrylate or methacrylate; 2-naphthyl acrylate or methacrylate; 2-(2-naphthyloxy)ethyl acrylate or methacrylate; and mixtures thereof.

10. The element of claim 7 wherein said monomer is selected from the group consisting of 2-phenoxyethyl acrylate, 2-phenoxyethyl methacrylate, phenol ethoxylate monoacrylate, 2-(p-chlorophenoxy)ethyl acrylate, p-chlorophenyl acrylate, phenyl acrylate, 2-phenylethyl acrylate, 2-(1-naphthyloxy)ethyl acrylate, o-biphenyl methacrylate, o-biphenyl acrylate, and mixtures thereof.

11. A process for preparing a volume transmission hologram comprising:
    (a) forming, on a reflective backing, a photopolymerizable layer consisting essentially of
        (1) a solvent soluble, thermoplastic polymeric binder selected from the group consisting of cellulose esters, polystyrene, copolymers of styrene containing at least about 60% styrene, and poly-

(methyl methacrylate);

(2) at least one liquid ethylenically unsaturated monomer capable of addition polymerization and having a boiling point above 100° C,

(3) a free radical generating system activatable by actinic radiation;

to form a photosensitive element, and

(b) exposing the photosensitive element to modulated actinic radiation bearing holographic information, wherein the reference and object beams enter the photopolymerizable layer on the same side.

12. The process of claim 11 wherein either said monomer or said binder contains a substituent selected from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine and mixtures thereof; and the other constituent is substantially free of said substituent.

13. The process or claim 12 wherein said monomer has a boiling point greater than 150° C.

14. The process of claim 12 wherein said binder is selected from the group consisting of cellulose esters, polystyrene, copolymers of styrene containing at least about 60% styrene, and poly(methyl methacrylate).

15. The process of claim 12 wherein said binder is selected from the group consisting of cellulose acetate butyrate, polystyrene, poly(methyl methacrylate), 70:30 poly(styrene-methyl methacrylate), and 75:25 poly(styrene-acrylonitrile).

16. The process of claim 12 wherein said monomer is selected from the group consisting of 2-phenoxyethyl acrylate, 2-phenoxyethyl methacrylate, phenol ethoxylate monoacrylate, 2-(p-chlorophenoxy)ethyl acrylate, p-chlorophenyl acrylate, phenyl acrylate, 2-phenylethyl acrylate, 2-(1-naphthyloxy)ethyl acrylate, o-biphenyl methacrylate, o-biphenyl acrylate, and mixtures thereof.

17. The process of claim 12 in which a solid ethylenically unsaturated monomer is also present.

18. The process of claim 17 in which the solid ethylenically unsaturated monomer contains a carbazole group.

19. The process of claim 17 in which said solid ethylenically unsaturated monomer is selected from the group consisting of N-vinyl carbazole; 2,4,6-tribromophenyl acrylate or methacrylate; pentachlorophenyl acrylate or methacrylate; 2-naphthyl acrylate or methacrylate; 2-(2-naphthyloxy)ethyl acrylate or methacrylate; and mixtures thereof.

20. The process of claim 17 wherein said monomer is selected from the group consisting of 2-phenoxyethyl acrylate, 2-phenoxyethyl methacrylate, phenol ethoxylate monoacrylate, 2-(o-chlorophenoxy)ethyl acrylate, p-chlorophenyl acrylate, phenyl acrylate, 2-phenylethyl acrylate, 2-(1-naphthyloxy)ethyl acrylate, o-biphenyl methacrylate, o-biphenyl acrylate, and mixtures thereof.

Fig. 1

EP 0 435 147 A2